# EUROPEAN PATENT SPECIFICATION

(11) **EP 3 750 854 B1**
(45) Date of publication and mention of the grant of the patent: **17.12.2025**
(21) Application number: 19751622.2
(22) Date of filing: 17.01.2019
(51) Int. Cl.: H05B 7/085, C03B 20/00, C30B 29/06, F27B 3/08, F27D 11/08

(54) **CARBON ELECTRODE AND PRODUCTION METHOD FOR QUARTZ GLASS CRUCIBLE**
KOHLENSTOFFELEKTRODE UND HERSTELLUNGSVERFAHREN FÜR QUARZGLASTIEGEL
ÉLECTRODE EN CARBONE ET PROCÉDÉ DE PRODUCTION DE CREUSET EN VERRE DE QUARTZ

(30) Priority: 06.02.2018 JP 2018019591
(43) Date of publication of application: 16.12.2020
(73) Proprietor: Shin-Etsu Quartz Products Co., Ltd., Tokyo 141-0032 (JP)
(72) Inventor: TOMOKUNI, Kazuki, Echizen-shi, Fukui 915-8535 (JP)
(74) Representative: Wibbelmann, Jobst
(86) International application number: PCT/JP2019/001172
(87) International publication number: WO 2019/155837

(56) References cited:
- EP-A1- 0 693 461
- WO-A1-2004/063651
- DE-A1- 2 262 442
- JP-A- 2002 530 258
- JP-A- 2007 273 206
- JP-A- H0 826 759
- JP-U- S60 166 998

## Description

### TECHNICAL FIELD

The present invention relates to a carbon electrode, and relates to a method for manufacturing a quartz glass crucible using the carbon electrode.

### BACKGROUND ART

Conventionally, a silicon single crystal used as a substrate for a single crystal semiconductor material has been manufactured by the so-called Czochralski method in which a polycrystalline silicon is melted in a quartz glass crucible and this is grown as a crystal on a seed crystal to manufacture the silicon single crystal. There are several types of the quartz glass crucible used in the above-described manufacturing method depending on manufacturing methods, but practically, a translucent quartz glass crucible obtained by a method for manufacturing a quartz glass crucible by charging silicon dioxide powder (raw quartz powder) along an inner surface of a hollow mold that can be rotated and heating the silicon dioxide powder to melt by an arc discharge using a carbon electrode while rotating the mold has been used. The translucent quartz glass crucible has advantages of many bubbles being dispersed to make the distribution of heat uniform, and being stronger compared to other crucibles so that a crucible of any size can be manufactured.

Conventionally, there has been a problem that even when a silicon single crystal is grown using the translucent quartz glass crucible, crystallization becomes unstable in the process and crystallization rate (the proportion of polycrystal that becomes a single crystal) is decreased. A cause for this includes the fact that a sublimation component of the silicon dioxide which is a starting material condenses and falls to form a microbubble aggregate which undergoes thermal expansion and partially delaminates the inner surface, and the delaminated quartz fragment is mixed into the melted silicon. In order to solve such a problem, a method for manufacturing a quartz glass crucible having a thick transparent layer by heating the inner surface of the crucible to melt to form a transparent layer, or by scattering molten silicon dioxide powder to form the thick transparent layer has been suggested. However, neither of the above-described manufacturing methods can eliminate microbubble aggregates sufficiently, and a silicon single crystal cannot be pulled with a favorable crystallization rate with the quartz glass crucibles. In addition, in the above-described heat-melting process, the inner surface of the obtained crucible is contaminated by selective evaporation/condensation of silicon dioxide and trace impurities contained therein or by scattering, etc. of ash content that accompanies wearing of the carbon electrode, and even when a high-purity starting material is used, it is not possible to fabricate a corresponding inner surface. For this reason, sufficient effect for suppressing crystal defects cannot be obtained even when a high-purity starting material is used.

The method for manufacturing a quartz glass crucible disclosed in Patent Document 1 has been suggested in order to solve these problems. This method is a method for manufacturing a quartz glass crucible by supplying silicon dioxide powder to a rotatable top-open mold, forming a silicon-dioxide-powder-charged layer along the inner surface of the mold, then heating to melt from the inside, and in the method, heat-melting is performed by covering the opening of the mold with a lid having two or more holes and the heat-melting is performed while ventilating the high-temperature gas atmosphere inside the mold through the holes. WO 2004/063651 A1 discloses a graphite electrode that can be effectively prevented from oxidizing and consuming during operation of an electric steel furnace, so that specific consumption of the electrode can be improved, wherein the graphite electrode is used in an electric steel furnace that is operated while the electrode projecting upward from a furnace cover is cooled by cooling liquid that is sprayed on the surface of the electrode, wherein the graphite electrode is characterized in that a concave and convex structure is formed on its surface.

### CITATION LIST

### PATENT LITERATURE

Patent Document 1: JP H08-026759 A
Patent Document 2: WO 2004/063651 A1

### SUMMARY OF INVENTION

### TECHNICAL PROBLEM

When a quartz glass crucible is manufactured, silica fume that is generated by raw silica being melted adheres to a carbon electrode and agglomerates, and thus falls on an inner surface of the quartz glass crucible. If the ratio of the part where this fallen material melted and solidified as it was to the inner surface area of the crucible is large, silicon single crystal pulling performance (single crystallization rate, etc.) is degraded.

In recent years, as the diameter of manufactured quartz glass crucibles become larger, 24 inches, 28 inches, and 32 inches (1 inch is 2.54 cm), electric power for melting has become high-powered, and silica fume generated while melting has increased, and for this reason, it has become impossible to prevent fallen material due to agglomerated silica fume sufficiently only by the method of Patent Document 1.

The present invention has been accomplished in view of the above circumstances, and an object thereof is to provide a carbon electrode that can suppress agglomeration of silica fume on the carbon electrode while manufacturing a quartz glass crucible.

### SOLUTION TO PROBLEM

To solve the above problem, the present invention provides a carbon electrode used for an arc discharge for manufacturing a quartz glass crucible, wherein at least one of a concave pattern and a convex pattern is formed on a surface of the carbon electrode in a range of 50 mm to 130 mm in a longitudinal direction of the carbon electrode from an end portion where the arc discharge takes place, wherein at least one of a plurality of concave portions and a plurality of convex portions are formed as the at least one of the concave pattern and the convex pattern, and a depth of the concave portions or a height of the convex portions is 2.0 mm or more and 10.0 mm or less.

The inventive carbon electrode can inhibit the agglomeration of silica fume that adheres to the carbon electrode during arc melting by having a concave pattern or a convex pattern formed in at least a range of 50 mm to 130 mm in a longitudinal direction as described. The growth-inhibited silica fume is light in weight, and therefore, is discharged outside the system by an arc gas flow blowing up from inside the crucible and does not fall into the quartz glass crucible. In this manner, agglomeration of silica fume while manufacturing the quartz glass crucible can be suppressed.

In this event, at least one of a plurality of concave portions and a plurality of convex portions are formed as the at least one of the concave pattern and the convex pattern, and a depth of the concave portions or a height of the convex portions is 2.0 mm or more and 10.0 mm or less, and preferably with a surface of the carbon electrode not having the concave portions or the convex portions formed as a reference surface, the at least one of the concave portions and the convex portions are present in an area ratio of 10% or more and 90% or less in any range of 20 mm in the longitudinal direction × 20 mm in a circumferential direction of the carbon electrode within the range of 50 mm to 130 mm in the longitudinal direction of the carbon electrode.

Such concave portions or convex portions make it possible to more effectively inhibit the agglomeration of silica fume that adheres to the carbon electrode.

Furthermore, at least one of a groove and a projection can be formed as the at least one of the concave pattern and the convex pattern.

As described, the concave pattern or the convex pattern can be, as specific shapes, a groove or a projection.

Furthermore, in the inventive carbon electrode, a screw groove can be formed as the at least one of the concave pattern and the convex pattern, and a depth of the screw groove can be 2.0 mm or more and 10.0 mm or less, and a pitch of the screw groove can be 1.0 mm or more and 10 mm or less.

The agglomeration of silica fume that adheres to the carbon electrode can also be inhibited by forming such a screw groove.

Furthermore, the present invention provides a method for manufacturing a quartz glass crucible including the steps of: preparing raw quartz powder which is to be a starting material for the quartz glass crucible to form into a crucible shape, and performing an arc discharge using any carbon electrode described above to melt the raw quartz powder formed into the crucible shape.

The inventive carbon electrode can inhibit the agglomeration of silica fume that adheres to the carbon electrode during arc melting as described above. The growth-inhibited silica fume is light in weight, and therefore, is discharged outside the system by an arc gas flow blowing up from inside the crucible and does not fall into the quartz glass crucible. Therefore, by the inventive method for manufacturing a quartz glass crucible, agglomeration of silica fume while manufacturing the quartz glass crucible can be suppressed.

### ADVANTAGEOUS EFFECTS OF INVENTION

The inventive carbon electrode can inhibit the agglomeration of silica fume that adheres to the carbon electrode by having a concave pattern or a convex pattern formed in at least a range of 50 mm to 130 mm from an end portion in a longitudinal direction. The growth-inhibited silica fume is light in weight, and therefore, is discharged outside the system by an arc gas flow blowing up from inside the crucible and does not fall into the quartz glass crucible. In this manner, agglomeration of silica fume while manufacturing the quartz glass crucible can be suppressed. In this manner, a quartz glass crucible having a quartz glass crucible inner surface with uniform characteristics can be provided. Accordingly, using such a quartz glass crucible, a single crystal can be manufactured with a good yield and productivity.

### BRIEF DESCRIPTION OF DRAWINGS

FIG. 1 is a schematic view showing examples of concave patterns and convex patterns for the inventive carbon electrode.
FIG. 2 is a schematic view for explaining an area ratio in a region where a concave pattern or a convex pattern is present on the inventive carbon electrode.

### DESCRIPTION OF EMBODIMENTS

Hereinafter, the present invention will be described more specifically with reference to the drawings.

The inventive carbon electrode is a carbon electrode used for an arc discharge for manufacturing a quartz glass crucible. The quartz glass crucible manufactured using the inventive carbon electrode is particularly suitable as a quartz glass crucible used as a quartz glass crucible for pulling a single crystal silicon, but is not limited thereto, and the inventive carbon electrode can be used for manufacturing a quartz glass crucible for other uses. The inventive carbon electrode has at least one of a concave pattern and a convex pattern formed on a surface of the carbon electrode in at least a range of 50 mm to 130 mm in a longitudinal direction of the carbon electrode from an end portion where the arc discharge takes place, wherein at least one of a plurality of concave portions and a plurality of convex portions are formed as the at least one of the concave pattern and the convex pattern, and a depth of the concave portions or a height of the convex portions is 2.0 mm or more and 10.0 mm or less.

At least one of a plurality of concave portions and a plurality of convex portions are formed as the at least one of the concave pattern and the convex pattern. Of course, both a concave portion and a convex portion may be formed. Furthermore, at least one of a groove and a projection is preferably formed as the at least one of the concave pattern and the convex pattern.

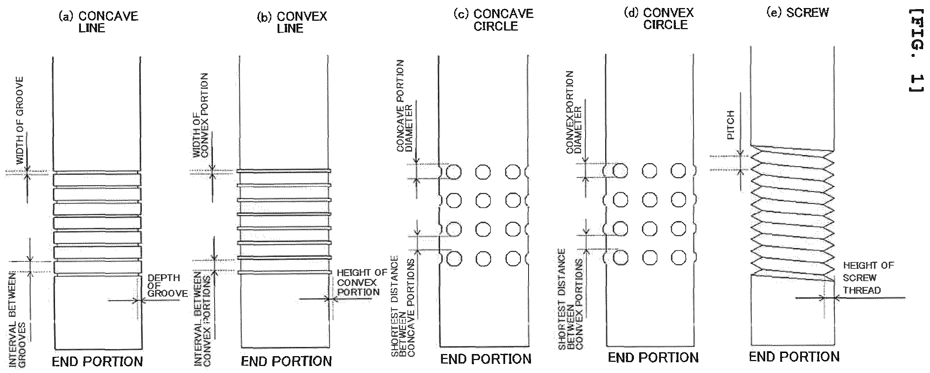

Examples of concave patterns and convex patterns for the inventive carbon electrode are shown in FIG. 1 (a) to (e).

FIG. 1 (a) is noted as "concave line", and this is an embodiment in which the carbon electrode has a plurality of concave portions on the surface, and the plurality of concave portions are formed as a plurality of ring-shaped grooves. In addition, FIG. 1 (b) is noted as "convex line", and this is an embodiment in which the carbon electrode has a plurality of convex portions on the surface, and the plurality of convex portions are formed as a plurality of ring-shaped projections.

The depth of the concave portions or a height of the convex portions is 2.0 mm or more and 10.0 mm or less. That is, in the example of FIG. 1 (a), the depth of the grooves (the depth of the concave portions) is preferably 2.0 mm or more and 10.0 mm or less. In the example of FIG. 1 (b), a height of the projection (the height of the convex portions) is preferably 2.0 mm or more and 10.0 mm or less. Agglomeration of silica fume that adheres to the carbon electrode can be inhibited more effectively with such concave portions or convex portions.

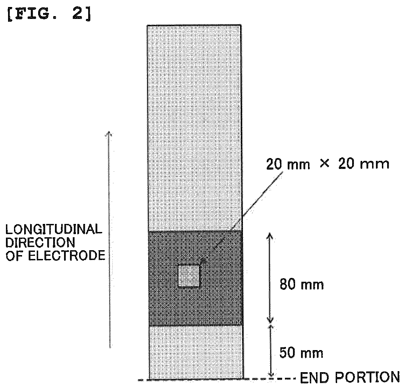

Furthermore, with a surface of the carbon electrode not having the concave portions or the convex portions formed as a reference surface, the at least one of the concave portions and the convex portions are preferably present in an area ratio of 10% or more and 90% or less in any range of 20 mm in the longitudinal direction × 20 mm in a circumferential direction of the carbon electrode within the at least the range of 50 mm to 130 mm in the longitudinal direction of the carbon electrode. That is, the at least one of the concave portions and the convex portions are preferably present in an area ratio of 10% or more and 90% or less in the range of 20 mm in the longitudinal direction × 20 mm in the circumferential direction of the carbon electrode shown schematically in FIG. 2. The width of the groove and the interval between the grooves shown in FIG. 1 (a) can be set so as to satisfy this area ratio. The width of the convex portions and the interval between the convex portions shown in FIG. 1 (b) can also be set thus.

FIG. 1 (c) and FIG. 1 (d) are different embodiments of the present invention. FIG. 1 (c) is noted as "concave circle", and this is an embodiment in which the carbon electrode has a plurality of concave portions on the surface, and the concave portions are formed as hemispherical dents. In addition, FIG. 1 (d) is noted as "convex circle", and this is an embodiment in which the carbon electrode has a plurality of convex portions on the surface, and the convex portions are formed as hemispherical projections. As in FIG. 1 (a) and (b), the depth of the concave portions is preferably 2.0 mm or more and 10.0 mm or less in the example of FIG. 1 (c), and the height of the convex portions is preferably 2.0 mm or more and 10.0 mm or less in the example of FIG. 1 (d).

Furthermore, in the embodiments of FIG. 1 (c) and (d) too, the at least one of the concave portions and the convex portions are preferably present in an area ratio of 10% or more and 90% or less in the range of 20 mm in the longitudinal direction × 20 mm in the circumferential direction of the carbon electrode shown schematically in FIG. 2. This area ratio can be satisfied by appropriately setting the concave portion diameter and the shortest distance between the concave portions shown in FIG. 1 (c). In addition, this area ratio can be satisfied by appropriately setting the convex portion diameter and the shortest distance between the convex portions shown in FIG. 1 (d).

Examples of concave portions or convex portions with a ring shape are shown in FIG. 1 (a) and (b), and concave portions or convex portions with a hemispherical shape in FIG. 1 (c) and (d), but the shapes of the concave portions or the convex portions are not limited thereto. Moreover, each of the shapes may be combined.

Another different embodiment of the present invention is shown in FIG. 1 (e). In this embodiment, a screw groove is formed as the at least one of the concave pattern and the convex pattern. In this case, the depth of the screw groove (that is, the height of the screw thread) is preferably 2.0 mm or more and 10.0 mm or less, and the pitch of the screw groove is preferably 1.0 mm or more and 10 mm or less. Note that in this embodiment with the screw groove formed, the shape of the screw portion such as the shape of the screw thread is not particularly limited. For example, a cross-sectional shape of the screw thread can be a triangle (that is, the top of the screw thread is configured to be a line) as shown in FIG. 1 (e). In addition, the cross-sectional shape of the screw thread can be a trapezoid (that is, the top of the screw thread is flat). Similarly, the shape of the bottom of the screw thread is also not particularly limited.

If there are no concave portions or convex portions on a carbon electrode, part of a silica powder is vaporized while being melted when manufacturing a quartz glass crucible, and silica fume that is cooled on the carbon electrode is deposited on the carbon electrode. In the present invention, the agglomeration of silica fume that adheres to the carbon electrode can be inhibited by adding, as described above, concavities or convexities in a range of 50 mm to 130 mm from the end of the carbon electrode where silica fume is liable to be deposited. The growth-inhibited silica fume is light in weight, and therefore, is discharged outside the system by an arc gas flow blowing up from inside the crucible and does not fall into the quartz glass crucible. During arc melting, deposition of silica fume is automatically suppressed since the carbon electrode end where the arc discharge takes place has a high temperature. Therefore, there is no necessity for concavities or convexities in a range of 50 mm from the electrode end. However, concavities or convexities may also be present in the range of 50 mm from the electrode end. In addition, regarding the electrode further up than 130 mm from the end, the deposition of the adhered silica fume is small compared to the electrode 50 mm to 130 mm from the end, and since the electrode further up than 130 mm is close to the exhaust port or the like at the time of arc discharge, the silica fume is easily discharged outside the system. Therefore, there is no necessity to form concavities or convexities. However, concavities or convexities may also be present in this range.

In addition, the present invention can be applied not only to a carbon electrode with a round bar shape having an almost constant diameter, but also to a carbon electrode having part of the diameter larger than other regions, etc.

The present invention also provides a method for manufacturing a quartz glass crucible using the above-described carbon electrode. This method for manufacturing a quartz glass crucible includes the steps of: preparing raw quartz powder which is to be a starting material for the quartz glass crucible to form into a crucible shape, and performing an arc discharge using the inventive carbon electrode described above to melt the raw quartz powder formed into the crucible shape. Since there are few defects on the surface of a quartz glass crucible thus obtained, the quartz glass crucible is suitable for manufacturing a single crystal.

### EXAMPLE

Hereinafter, the present invention will be described more specifically with reference to Examples of the present invention and Comparative Examples, but the present invention is not limited to these Examples, and there is no doubt that various modifications can be carried out unless deviating from the technical concept of the present invention.

### (Common conditions of the Examples and the Comparative Examples)

A quartz glass crucible with a diameter of 32 inches (approximately 81 mm) was manufactured by an arc discharge method using a round-bar-shaped carbon electrode with a diameter of 57.3 mm, and the quartz glass crucible was evaluated. When the total surface area of a plurality of silica fumes that fell into the manufactured crucible was 50 mm² or more, this was defined as an adhesion defect, and the adhesion defect occurrence rate was investigated. An adhesion defect occurrence rate of 4% or less was determined as acceptable. In particular, an adhesion defect occurrence rate of 2% or less was determined as acceptable (excellent). An adhesion defect occurrence rate of more than 4% was determined as unacceptable. In addition, a case where formation of the arc was insufficient or unstable was evaluated as having a somewhat defective arc.

### (Examples 1-1 to 1-9)

A carbon electrode in the embodiment shown in FIG. 1 (a) was fabricated. Ring-shaped grooves were formed on the round-bar-shaped electrode. The number of ring-shaped grooves (concave portions), the positions of the grooves (the distances from the electrode end), the intervals between the grooves, the width of the grooves, and the depth of the grooves were as shown in Table 1. The ratio (%) of the concave portions taking up the range of 20 mm × 20 mm shown in FIG. 2 is as shown in Table 1. Examples 1-1 to 1-9 are all examples in which the grooves were formed in at least a range of 50 mm to 130 mm in a longitudinal direction of the carbon electrode from the end portion of the carbon electrode where the arc discharge takes place. A quartz glass crucible was manufactured using this carbon electrode.

### (Comparative Examples 1-1 to 1-3)

In Comparative Example 1-1, no grooves were formed, and a round-bar carbon electrode with no other concavities or convexities formed was used. In Comparative Examples 1-2 and 1-3, grooves were formed, but the grooves were formed in parts that were not in at least a range of 50 mm to 130 mm in a longitudinal direction of the carbon electrode from the end portion of the carbon electrode where the arc discharge takes place. The formed grooves were as described in Table 1.

**[Table 1]**

| | Number of ring-shaped grooves (concave portions) | Positions of grooves: distance from electrode end (mm) | Interval between grooves (mm) | Width of grooves (mm) | Depth of grooves (mm) | Ratio (%) of concave portions taking up 20 mm × 20 mm range (within range of 50 mm to 130 mm) | Adhesion defect occurrence rate (%) | Adhesion acceptability | Arc |
|---|---|---|---|---|---|---|---|---|---|
| Example 1-1 | 4 | 50-52, 70-72, 90-92, 110-112 | 18 | 2 | 2 | 10 | 1.3 | Acceptable (excellent) | Favorable |
| Example 1-2 | 4 | 50-52, 70-72, 90-92, 110-112 | 18 | 2 | 10 | 10 | 1. 1 | Acceptable (excellent) | Favorable |
| Example 1-3 | 8 | 50-52, 60-62, 70-72, 80-82, 90-92, 100-102, 110-112, 120-122 | 8 | 2 | 2 | 20 | 1.0 | Acceptable (excellent) | Favorable |
| Example 1-4 | 4 | 52-70, 72-90, 92-110, 112-130 | 2 | 18 | 2 | 90 | 1.5 | Acceptable (excellent) | Favorable |
| Comparative Example 1-1 | No grooves | No grooves | No grooves | 0 | 0 | - | 5.7 | Unacceptable | Favorable |
| Example 1-5 | 2 | 70-72, 110-112 | 38 | 2 | 2 | 0-10 | 3.0 | Acceptable | Favorable |
| Example 1-6 | 2 | 50-89, 91-130 | 2 | 39 | 2 | 90-100 | 3.5 | Acceptable | Favorable |
| Example 1-7 | 4 | 50-52, 70-72, 90-92, 110-112 | 18 | 2 | 15 | 10 | 3.1 | Acceptable | Somewhat defective |
| Example 1-8 | 4 | 50-52, 70-72, 90-92, 110-112 | 18 | 2 | 1 | 10 | 3.5 | Acceptable | Favorable |
| Example 1-9 | 3 | 10-12, 30-32, 50-52 | 18 | 2 | 2 | 0-10 | 3.0 | Acceptable | Favorable |
| Comparative Example 1-2 | 3 | 10-12, 25-27, 40-42 | 13 | 2 | 2 | 0 | 5.5 | Unacceptable | Favorable |
| Comparative Example 1-3 | 4 | 140-142, 160-162, 180-182, 200-202 | 18 | 2 | 2 | 0 | 5.5 | Unacceptable | Favorable |

As shown in Table 1, adhesion acceptability was acceptable in every case in Examples 1-1 to 1-9, where the grooves were formed in at least a range of 50 mm to 130 mm in a longitudinal direction of the carbon electrode from the end portion where the arc discharge takes place.

In particular, in Examples 1-1 to 1-4, the depth of the grooves was 2.0 mm or more and 10.0 mm or less, and the area ratio of the grooves taking up the range of 20 mm in the longitudinal direction × 20 mm in the circumferential direction of the carbon electrode was 10% or more and 90% or less, and adhesion acceptability was particularly excellent. In Example 1-7, arc formation was somewhat unstable, but an adhesion reduction effect was obtained.

### (Example 2-1)

A carbon electrode in the embodiment shown in FIG. 1 (b) was fabricated. Ring-shaped convex portions were formed on the round-bar-shaped electrode. The number of ring-shaped convex portions, the positions of the convex portions (the distances from the electrode end), the intervals between the convex portions, the width of the convex portions, and the height of the convex portions were as shown in Table 2. The ratio (%) of the convex portions taking up the range of 20 mm × 20 mm shown in FIG. 2 is as shown in Table 2. Example 2-1 is an example in which the convex portions were formed in at least a range of 50 mm to 130 mm in a longitudinal direction of the carbon electrode from the end portion of the carbon electrode where the arc discharge takes place. A quartz glass crucible was manufactured using this carbon electrode.

**[Table 2]**

| | Number of ring-shaped convex portions | Positions of convex portions: distance from electrode end (mm) | Interval between convex portions (mm) | Width of convex portions (mm) | Height of convex portions (mm) | Ratio (%) of convex portions taking up 20 mm × 20 mm range (within range of 50 mm to 130 mm) | Adhesion defect occurrence rate (%) | adhesion acceptability | Arc |
|---|---|---|---|---|---|---|---|---|---|
| Example 2-1 | 4 | 50-52, 70-72, 90-92, 110-112 | 18 | 2 | 2 | 10 | 1.3 | Acceptable (excellent) | Favorable |

As shown in Table 2, adhesion acceptability was acceptable (excellent) in Example 2-1.

### (Examples 3-1 and 3-2)

A carbon electrode in the embodiment shown in FIG. 1 (c) was fabricated. Concave portions which were hemispherical dents were formed on the round-bar-shaped electrode. The concave portion diameter, the positions of the concave portions (the distances from the electrode end), the shortest distance between the concave portions, and the depth of the concave portions were as shown in Table 3. The ratio (%) of the concave portions taking up the range of 20 mm × 20 mm shown in FIG. 2 is as shown in Table 3. Examples 3-1 and 3-2 are examples in which the concave portions were formed in at least a range of 50 mm to 130 mm in a longitudinal direction of the carbon electrode from the end portion of the carbon electrode where the arc discharge takes place. A quartz glass crucible was manufactured using this carbon electrode.

**[Table 3]**

| | Concave portion diameter (mm) | Positions of concave portions: distance from electrode end (mm) | Shortest distance between concave portions (mm) | Depth of concave portions (mm) | Ratio (%) of concave portions taking up 20 mm × 20 mm range (within range of 50 mm to 130 mm) | Adhesion defect occurrence rate (%) | Adhesion acceptability | Arc |
|---|---|---|---|---|---|---|---|---|
| Example 3-1 | 10 | 55-65, 75-85, 95-105, 115-125 | 10 | 2 | 19.6 | 1.5 | Acceptable (excellent) | Favorable |
| Example 3-2 | 5 | 57.5-62.5, 77.5-82.5, 97.5-102.5, 117.5-122.5 | 15 | 2 | 4.9 | 3.3 | Acceptable | Favorable |

As shown in Table 3, adhesion acceptability was acceptable in each case in Examples 3-1 and 3-2. In particular, in Example 3-1, the ratio of the concave portions taking up a range of 20 mm × 20 mm was an area ratio within the range of 10% or more and 90% or less, and adhesion defect occurrence rate was particularly excellent.

### (Examples 4-1 and 4-2)

A carbon electrode in the embodiment shown in FIG. 1 (d) was fabricated. Convex portions which were hemispherical projections were formed on the round-bar-shaped electrode. The convex portion diameter, the positions of the convex portions (the distances from the electrode end), the shortest distance between the convex portions, and the height of the convex portions were as shown in Table 4. The ratio (%) of the concave portions taking up the range of 20 mm × 20 mm shown in FIG. 2 is as shown in Table 4. Examples 4-1 and 4-2 are examples in which the convex portions were formed in at least a range of 50 mm to 130 mm in a longitudinal direction of the carbon electrode from the end portion of the carbon electrode where the arc discharge takes place. A quartz glass crucible was manufactured using this carbon electrode.

**[Table 4]**

| | Convex portion diameter (mm) | Positions of convex portions: distance from electrode end (mm) | Shortest distance between convex portions (mm) | Height of convex portions (mm) | Ratio (%) of convex portions taking up 20 mm × 20 mm range (within range of 50 mm to 130 mm) | Adhesion defect occurrence rate (%) | Adhesion acceptability | Arc |
|---|---|---|---|---|---|---|---|---|
| Example 4-1 | 10 | 55-65, 75-85, 95-105, 115-125 | 10 | 2 | 19.6 | 1.3 | Acceptable (excellent) | Favorable |
| Example 4-2 | 5 | 57.5-62.5, 77.5-82.5, 97.5-102.5, 117.5-122.5 | 15 | 2 | 4.9 | 3.8 | Acceptable | Favorable |

As shown in Table 4, adhesion acceptability was acceptable in each case in Examples 4-1 and 4-2. In particular, in Example 4-1, the ratio of the convex portions taking up a range of 20 mm × 20 mm was an area ratio within the range of 10% or more and 90% or less, and adhesion defect occurrence rate was particularly excellent.

### (Examples 5-1 to 5-8)

A carbon electrode in the embodiment shown in FIG. 1(e) was fabricated. A screw groove was formed in at least the range of 50 mm to 130 mm in the longitudinal direction of the carbon electrode from the end portion of the carbon electrode where the arc discharge takes place. The height of the screw thread (the depth of the screw groove), the position of the screw formation (the distance from the electrode end), and the pitch of the screw thread were as shown in Table 5. A quartz glass crucible was manufactured using this carbon electrode.

**[Table 5]**

| | Height of screw thread (mm) | Position of screw formation: distance from electrode end (mm) | Pitch (mm) | Adhesion defect occurrence rate (%) | Adhesion acceptability | Arc |
|---|---|---|---|---|---|---|
| Example 5-1 | 2 | 50-130 | 1 | 1.1 | Acceptable (excellent) | Favorable |
| Example 5-2 | 10 | 50-130 | 10 | 1.3 | Acceptable (excellent) | Favorable |
| Example 5-3 | 2 | 50-130 | 10 | 1. 4 | Acceptable (excellent) | Favorable |
| Example 5-4 | 1 | 50-130 | 2 | 2.7 | Acceptable | Favorable |
| Example 5-5 | 15 | 50-130 | 10 | 3.6 | Acceptable | Somewhat defective |
| Example 5-6 | 2 | 50-130 | 0.5 | 3.5 | Acceptable | Favorable |
| Example 5-7 | 10 | 50-130 | 15 | 3.6 | Acceptable | Favorable |
| Example 5-8 | 2 | 50-130 | 15 | 3.3 | Acceptable | Favorable |

As shown in Table 5, adhesion acceptability was acceptable in each case in Examples 5-1 to 5-8. In particular, Examples 5-1 to 5-3 are examples in which the depth of the screw groove was 2.0 mm or more and 10.0 mm or less and the pitch of the screw groove was 1.0 mm or more and 10 mm or less, and adhesion acceptability was particularly excellent. In Example 5-5, arc formation was somewhat unstable, but an adhesion reduction effect was obtained.

## Claims

1. A carbon electrode for an arc discharge for manufacturing a quartz glass crucible, wherein
at least one of a concave pattern and a convex pattern is formed on a surface of the carbon electrode in a range of 50 mm to 130 mm in a longitudinal direction of the carbon electrode from an end portion where the arc discharge takes place, wherein
at least one of a plurality of concave portions and a plurality of convex portions are formed as the at least one of the concave pattern and the convex pattern, and
a depth of the concave portions or a height of the convex portions is 2.0 mm or more and 10.0 mm or less.

2. The carbon electrode according to claim 1,
with a surface of the carbon electrode not having the concave portions or the convex portions formed as a reference surface, the at least one of the concave portions and the convex portions are present in an area ratio of 10% or more and 90% or less in any range of 20 mm in the longitudinal direction × 20 mm in a circumferential direction of the carbon electrode within the range of 50 mm to 130 mm in the longitudinal direction of the carbon electrode.

3. The carbon electrode according to claim 1 or 2, wherein at least one of a groove and a projection is formed as the at least one of the concave pattern and the convex pattern.

4. The carbon electrode according to any one of claims 1 to 3, wherein
a screw groove is formed as the at least one of the concave pattern and the convex pattern, and
a depth of the screw groove is 2.0 mm or more and 10.0 mm or less, and a pitch of the screw groove is 1.0 mm or more and 10 mm or less.

5. A method for manufacturing a quartz glass crucible comprising the steps of:
preparing raw quartz powder which is to be a starting material for the quartz glass crucible to form into a crucible shape, and
performing an arc discharge using the carbon electrode according to any one of claims 1 to 4 to melt the raw quartz powder formed into the crucible shape.

6. Use of a carbon electrode in a method for manufacturing a quartz glass crucible according to claim 5.

## Patentansprüche

1. Kohlenstoffelektrode für eine Lichtbogenentladung zur Herstellung eines Quarzglastiegels, wobei
ein konkaves Muster und/oder ein konvexes Muster auf einer Oberfläche der Kohlenstoffelektrode in einem Bereich von 50 mm bis 130 mm in einer Längsrichtung der Kohlenstoffelektrode von einem Endabschnitt, an dem die Lichtbogenentladung stattfindet, ausgebildet ist, wobei
eine Mehrzahl von konkaven Abschnitten und/oder eine Mehrzahl von konvexen Abschnitten als das konkave Muster und/oder das konvexe Muster ausgebildet ist, und
eine Tiefe der konkaven Abschnitte oder eine Höhe der konvexen Abschnitte 2,0 mm oder mehr und 10,0 mm oder weniger beträgt.

2. Kohlenstoffelektrode gemäß Anspruch 1,
wobei eine Oberfläche der Kohlenstoffelektrode, die die konkaven Abschnitte oder die konvexen Abschnitte nicht aufweist, als Referenzoberfläche ausgebildet ist, wobei die konkaven Abschnitte und/oder die konvexen Abschnitte in einem Flächenverhältnis von 10 % oder mehr und 90 % oder weniger in einem Bereich von 20 mm in der Längsrichtung × 20 mm in einer Umfangsrichtung der Kohlenstoffelektrode innerhalb des Bereichs von 50 mm bis 130 mm in der Längsrichtung der Kohlenstoffelektrode vorhanden sind.

3. Kohlenstoffelektrode gemäß Anspruch 1 oder 2, wobei eine Rille und/oder ein Vorsprung als das konkave Muster und/oder das konvexe Muster ausgebildet ist.

4. Kohlenstoffelektrode gemäß einem der Ansprüche 1 bis 3, wobei
eine Schraubnut als das konkave Muster und/oder das konvexe Muster ausgebildet ist, und
eine Tiefe der Schraubnut 2,0 mm oder mehr und 10,0 mm oder weniger beträgt und eine Steigung der Schraubnut 1,0 mm oder mehr und 10 mm oder weniger beträgt.

5. Verfahren zur Herstellung eines Quarzglastiegels, das die folgenden Schritte umfasst:
Herstellen von Rohquarzpulver, das als Ausgangsmaterial für den Quarzglastiegel dient, um es in eine Tiegelform zu bringen, und
Durchführen einer Lichtbogenentladung unter Verwendung der Kohlenstoffelektrode gemäß einem der Ansprüche 1 bis 4, um das zu einer Tiegelform geformte Rohquarzpulver zu schmelzen.

6. Verwendung einer Kohlenstoffelektrode in einem Verfahren zur Herstellung eines Quarzglastiegels gemäß Anspruch 5.

## Revendications

1. Électrode en carbone utilisée pour une décharge d'arc destinée à la fabrication d'un creuset en verre de quartz, dans laquelle
au moins un motif concave et un motif convexe sont formés sur une surface de l'électrode en carbone dans une plage allant de 50 mm à 130 mm dans un sens longitudinal de l'électrode en carbone à partir d'une partie d'extrémité où la décharge d'arc a lieu, dans laquelle
au moins une partie parmi une pluralité de parties concaves et une partie parmi une pluralité de parties convexes prennent la forme de l'au moins un parmi le motif concave et le motif convexe, et
la profondeur des parties concaves ou la hauteur des parties convexes est comprise entre 2,0 mm et 10,0 mm ou moins.

2. Électrode en carbone selon la revendication 1,
une surface de l'électrode en carbone ne présentant pas les parties concaves ou les parties convexes formées comme surface de référence, l' au moins une parmi les parties concaves et les parties convexes est présente dans un rapport de surface de 10 % ou plus et de 90 % ou moins dans une quelconque plage de 20 mm dans le sens longitudinal × 20 mm dans le sens circonférentiel de l'électrode en carbone dans la plage allant de 50 mm à 130 mm dans le sens longitudinal de l'électrode en carbone.

3. Électrode en carbone selon la revendication 1 ou 2, dans lequel au moins une parmi une rainure et une saillie prennent la forme de l'au moins un parmi le motif concave et le motif convexe.

4. Électrode en carbone selon l'une quelconque des revendications 1 à 3, dans lequel
une rainure de vis prend la forme de l'au moins un parmi le motif concave et le motif convexe, et
la profondeur de la rainure de vis est de 2,0 mm ou plus et 10,0 mm ou moins, et le pas de la rainure de vis est 1,0 mm ou plus et 10 mm ou moins.

5. Procédé de fabrication d'un creuset en verre de quartz comprenant les étapes consistant à:
préparer de la poudre de quartz brute qui servira de matière première pour le creuset en verre de quartz afin de lui donner la forme d'un creuset, et
effectuer une décharge électrique à l'aide de l'électrode en carbone selon l'une quelconque des revendications 1 à 4 afin de faire fondre la poudre de quartz brute pour lui donner la forme de creuset.

6. Utilisation d'une électrode en carbone selon un procédé de fabrication d'un creuset en verre quartz selon la revendication 5.
